# EUROPEAN PATENT SPECIFICATION

(11) **EP 0 378 543 B1**
(45) Date of publication and mention of the grant of the patent: **06.10.1993**
(21) Application number: 88906451.5
(22) Date of filing: 22.06.1988
(51) Int. Cl.: C23C 16/00

(54) **GAS INJECTOR APPARATUS FOR CHEMICAL VAPOR DEPOSITION REACTORS**
GASEINSPRITZVORRICHTUNG FÜR REAKTOREN FÜR DEN CHEMISCHEN DAMPFNIEDERSCHLAG
APPAREIL D'INJECTION DE GAZ POUR REACTEURS DE DEPOSITION EN PHASE GAZEUSE PAR PROCEDE CHIMIQUE

(43) Date of publication of application: 25.07.1990
(73) Proprietor: ADVANCED SEMICONDUCTOR MATERIALS AMERICA, INC., Phoenix, Arizona 85034 (US)
(72) Inventor: BARNETT, Lewis, C., Tempe, AZ 85282 (US); FERRO, Armand, Pasquale, Scottsdale, AZ 85282 (US); HAWKINS, Mark, Richard, Mesa, AZ 85202 (US)
(74) Representative: Downey, William Gerrard
(86) International application number: US8802125
(87) International publication number: WO8912703

(56) References cited:
- US-A- 3 293 074
- US-A- 3 338 209
- US-A- 3 516 811
- US-A- 3 750 620
- US-A- 3 785 853
- US-A- 4 033 286
- US-A- 4 434 742
- US-A- 4 499 853
- US-A- 4 583 492

## Description

### Background of the Invention

The present invention relates generally to a gas injector apparatus for use in conjunction with chemical vapor deposition (hereinafter referred to as "CVD") reactors used in processing semiconductor wafers. More particularly, the present invention relates to a gas injector apparatus for use in a single-wafer epitaxial deposition system where stringent control over deposition kinetics and uniformity of the deposited layer is necessary.

Conventional CVD reactors are typically classified according to the orientation of the gas flow with respect to the substrate surface. Commercial epitaxial deposition reactors are typically classified as vertical, horizontal or barrel systems. Vertical reactors employ a gas flow which is directed vertically toward the wafer surface. Barrel reactor systems employ a barrel-shaped susceptor wherein the wafers are placed vertically on the outer surfaces of the susceptor and gas is introduced vertically into the reaction chamber and flows substantially horizontally across the wafer surface. Finally, in horizontal CVD reactors the wafers are placed horizontally on a susceptor and the reactant gas stream flows horizontally across the wafer surface. Conventional horizontal CVD systems utilize a laminar gas flow to deposit the reactant species on the wafer.

Typically, a reactive gas mixture bearing the material to be deposited is introduced into a pre-heated reaction chamber containing the semiconductor substrate on a heated susceptor. As the gas is introduced into the reaction chamber, the laminar gas flow transports the deposition material to the substrate. The deposition material is deposited onto the substrate and, concurrently, depleted from the reactant gas flow. This simultaneous deposition and depletion establishes a concentration gradient across the substrate surface. The depletion of the deposition material from the reactant gas flow invariably leads to non-uniform deposition across the wafer surface due to decreased concentrations of the deposition material in the reactive gas mixture as it flows across the substrate surface.

Deposition reaction dynamics are critical to achieving a uniform deposition rate and deposition thickness. The deposition reaction is substantially temperature and flow dependent. Maintaining a uniform gas temperature and flow profile is important for achieving a substantially uniform deposition rate onto the substrate surface. In conventional CVD reactors, reactant gas typically flows between the heated susceptor and wafers and the cold reactor wall. Deposition uniformity is determined by the resulting thermal and mass transport boundary layers in the gas. U.S. Patent No. 4,499,853 issued February 19, 1985 to Edward A. Miller discloses a gas distributor tube for a CVD apparatus which provides a gas stream substantially free of turbulence. As exemplified by U.S. Patent No. 4,499,853, those skilled in the art deem the provision of a uniform velocity gas flow is desirable to increase deposition uniformity. Thus, in conventional horizontal CVD systems the state of the art teaches uniformity of both temperature and flow velocity across the wafer surface.

The present invention provides a gas injector apparatus which shapes a uniform velocity gas flow in order to present substantially uniform concentration gradients of the reactive species in the gas flow to all areas of the wafer surface. Presentation of a shaped velocity gas flow to the curvilinear leading and trailing edges of the wafer increases thickness uniformity of the deposited material across the wafer surface.

### SUMMARY OF THE INVENTION

Accordingly, it is a broad object of the present invention to provide a gas injector apparatus for improving deposition uniformity in single-wafer CVD epitaxial reactors.

It is another object of the present invention to provide a gas injector apparatus which creates a uniform velocity flow of reactant gas within the apparatus.

It is another object of the present invention to provide a gas injection apparatus for a chemical vapor deposition reactor capable of shaping the velocity profile of a uniform velocity flow of reactant gas as it flows across the substrate surface.

It is another object of the present invention to provide a gas injector apparatus which creates a uniform gas flow, shapes the velocity profile of the gas flow and exposes the wafer surface area to substantially uniform concentration gradients of the reactant species in the gas flow.

It is still another object of the present invention to provide a gas injector apparatus for a chemical vapor deposition reactor which provides a uniform and controlled concentration of the deposited material.

These and other objects, features and advantages of the present invention will become more apparent from the following more detailed description of the preferred embodiments of the present invention with reference to the accompanying Figures in which like elements are identified by like reference numerals.

According to the present invention there is provided a gas injector apparatus for an epitaxial deposition reactor, comprising: a remote manifold having an upper chamber, a plenum chamber and a outlet opening associated with said plenum chamber; a hollow tubular member having at least one aperture passing therethrough, said hollow tubular member being connected to a source of gas and disposed coaxially within said upper chamber of said remote manifold; a hollow baffle member, having a plurality of apertures passing therethrough, coaxially surrounding said hollow tubular member and coaxially disposed within said upper chamber of said remote manifold; a plate member having a plurality of openings passing therethrough, said plate member being coupled to said remote manifold such that said plurality of openings in said plate member communicate with said outlet opening associated with said plenum chamber or said remote manifold: flow restriction means associated with each of said plurality of openings in said plate member, for regulating a flow of gas through said each of said plurality of openings in said plate member; a main injector body having an upper surface and a front surface and an L-shaped chamber within said main injector body communicating with each of said upper surface and said front surface, said main injector body being coupled to said plate member such that said plurality of openings in said plate member communicate with upper surface and said L-shaped chamber of said main injector body.

### BRIEF DESCRIPTION OF DRAWINGS

Figure 1 is a schematic representation of a top view of a prior art CVD reactor for injecting a uniform gas flow into a multi-substrate processing system.

Figure 2 is a sectional top view illustrating disparate flow path distances across the substrate surface in a single substrate CVD reactor.

Figure 3 is a sectional top view illustrating a gas injector for introducing reactant gas flow having a predetermined shaped velocity profile in a single substrate CVD epitaxial deposition reactor.

Figure 4 is an exploded perspective view of the gas injector apparatus of the present invention.

Figure 5 is a front elevational partial cross-sectional view of a base portion of the gas injector apparatus of the present invention.

Figure 6 is a side elevational cross-sectional view taken along line 6-6 of Figure 5.

Figure 7 is a top elevational view of the base portion of the gas injector apparatus of the present invention.

Figure 8 is a side elevational partial cross-sectional view of a remote manifold portion of the gas injector apparatus of the present invention.

Figure 9 is a side elevational partial cross-sectional view taken along line 9-9 of Figure 8.

### Detailed Description of the Preferred Embodiment

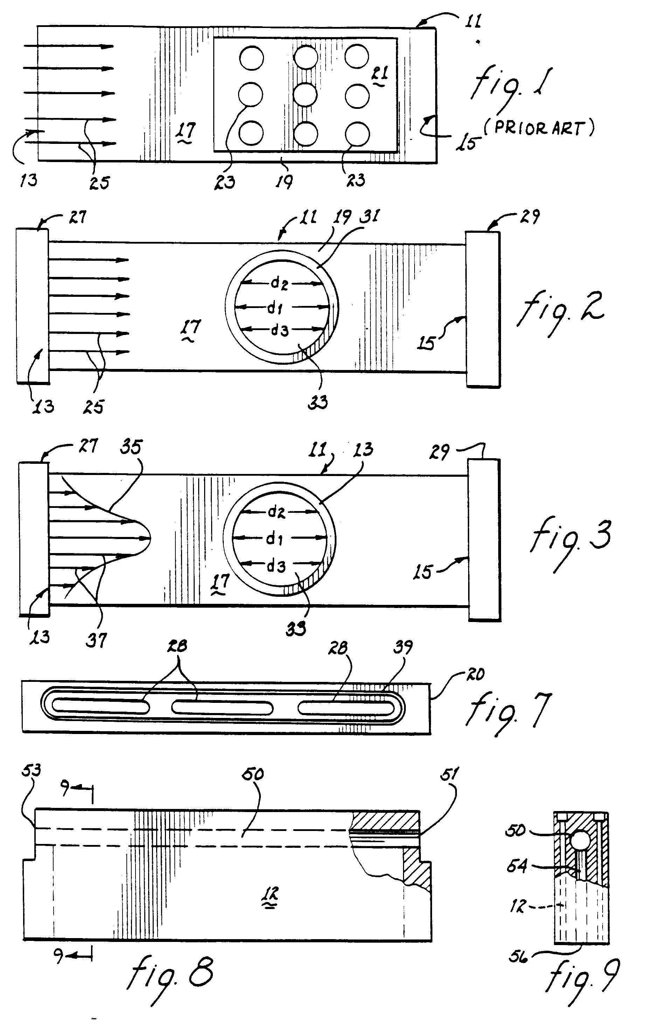

Figure 1 represents a CVD system 11 for multi-substrate 23 processing. The reactor 11 includes a reactant gas input 13 which supplies reactant gases into a hollow interior 17 of the reactor 11. Gas flow 25 is injected into an input portion 13 of the reactor 11 and enters the hollow interior 17 at a substantially uniform velocity and with a substantially laminar profile. Gas flow 25 passes across susceptor 21 and substrates 23 with a uniform velocity and deposits the reactant species carried in the gas flow 25 upon the substrates 23. After deposition of the reactant species onto the substrates 23 and the depletion of the reactant species from the gas flow 25, the gas flow 25 is withdrawn from the hollow interior 17 of the reactor 11 by an exhaust port 15. The uniform velocity of gas flow 25 is diagrammatically represented by equal length arrows represent uniform magnitudes of velocity across the width of the hollow interior 17 of reactor 11. Where there are multiple substrate, injecting the gas flow 25 into the hollow interior 17 and flowing the gas across the surface of each substrate has achieved relatively uniform deposition of the reactant species onto the substrates 23.

In single-substrate epitaxial deposition reactors, however, injection of a uniform velocity gas flow fails to achieve acceptable uniformity of the deposited layers. The introduction of a uniform velocity gas flow 25 in a single-substrate reactor is illustrated in Figure 2. It will be appreciated, by those skilled in the art, that as the uniform velocity gas flow 25 passes over the generally circular substrate 33 it encounters different substrate surface areas across the width of the substrate. As represented by the designations "d₁", "d₂", and "d₃" the curved profile of the substrate 33 requires the gas flow 25 to traverse varying distances. It will be observed that the gas flow 25 must pass over a greater distance "d₁" at the central area of the substrate, whereas the gas flow 25 only passes over relatively shorter distances "d₂" and "d₃" toward the lateral edges of the substrate.

The reactant gas flow 25 is, therefore, exposed to differing substrate surface areas which decrease toward the lateral surfaces of the substrate. Where the gas flow 25 is introduced into the hollow interior 15 with a uniform velocity profile, the gas flow 25 will pass through each of distances "d₁", "d₂", and "d₃" within the same time interval. The greater central surface area "d₁" causes a more rapid depletion of the reactant species and establishes unequal concentration gradients of the reactant species in the gas flow across the horizontal aspect of substrate 33. The unequal concentration gradients cause, in turn, non-uniform deposition of the reactant species onto the substrate 33.

After depletion of the reactant species from the gas flow 25, the spent gas is withdrawn from gas outlet 15 via gate or port 29.

Figure 3 illustrates the shaped velocity gas flow achieved by the present invention. Gas injector 27 supplies the reactant gas at input 13 of the reactor 11. A gas flow 37 is introduced into the hollow interior 17 of the reactor 11 having a predetermined shaped velocity profile, as represented by waveform envelope 35. As illustrated in Figure 3, gas flow 27 is represented by varying sized arrows representing different velocity magnitudes. It will be seen that the gas flow 37 is shaped to have a greater velocity toward the center of the envelope 35 and a lesser velocity toward the lateral edges of the substrate. The shaped velocity profile causes the gas flow 37 to pass over distances "d₁'", "d₂'" and "d₃'" in different time intervals. By selectively exposing area "d₁'" and areas "d₂'" and "d₃'" to differing gas flow velocities, the more rapid depletion of the reactant species in the central area "d₁'" is compensated for by the increased velocity of the gas flow in that area. Thus, the shaped velocity gas flow profile delivers greater quantities of the reactant species to the larger central surface area "d₁'" of the substrate. The relative smaller areas "d₂'" and "d₃'" are exposed to lesser gas flow velocities and, therefore, receive lesser quantities of the reactant species. After deposition, the spent gas exits outlet 15 via gate or port 29.

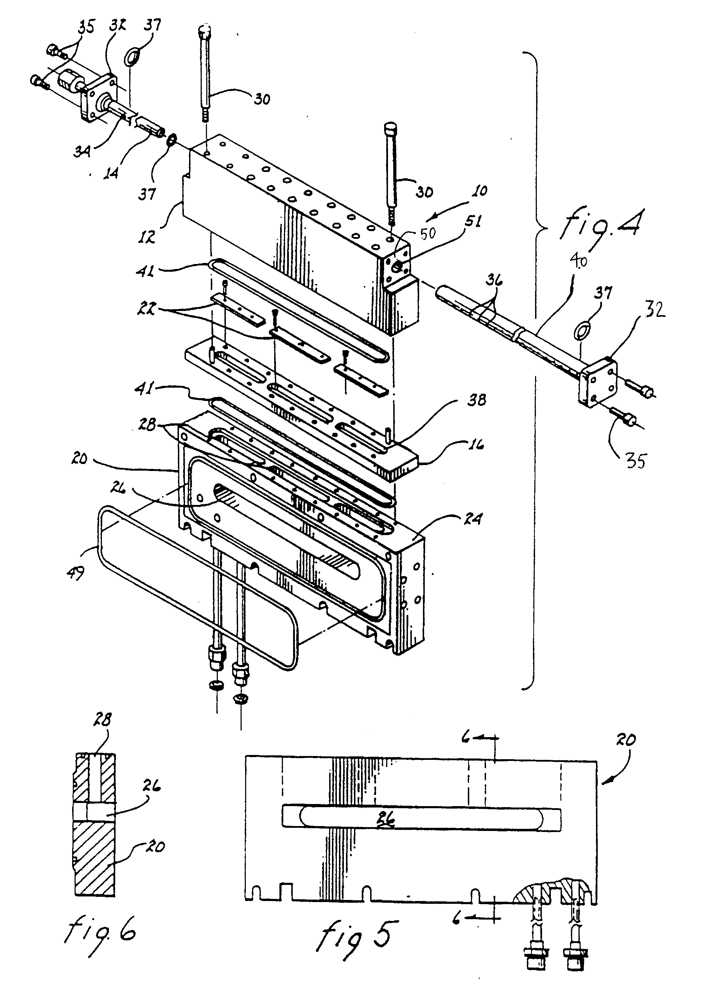

The shaped velocity gas flow profile of the present invention is achieved by a gas injector apparatus as illustrated, in its preferred embodiment, in Figures 4-9. In accordance with the preferred embodiment of the present invention there is provide a gas injector apparatus 10 for use principally in single-substrate epitaxial chemical vapor deposition reactors. The gas injector apparatus 10 consists generally of a remote manifold 12, a straight-walled plenum chamber 54, a shuttered and apertured plate 16 and an main injector body 20. Remote manifold 12 and plenum chamber 54 cooperate to provide a uniform velocity gas flow having a vertical directional vector which exits plenum chamber 54 via slot 56.

In order to create a uniform velocity gas flow within plenum chamber 54 of remote manifold 12, the reactant gas is introduced into remote manifold 12 through a hollow tubular member 14 which is coaxially disposed within a hollow baffle member 40. Hollow baffle member 40 is, in turn, coaxially disposed within an upper chamber 50 of remote manifold 12. According to the preferred embodiment of the present invention and as illustrated in Figures 4, 8 and 9, remote manifold 12 consists of plenum chamber 54, upper chamber 50 and slot 56. Upper chamber 50 extends laterally through an upper portion of remote manifold 12 and terminates at openings 51 at each of two side surfaces of the remote manifold 12. Hollow tubular member 14, having a gas inlet aperture 34 passing therethrough, is removably coupled to an opening 51 in one side surface of remote manifold 12 and passes into upper chamber 50 so that gas inlet aperture 34 is disposed within upper chamber 50. Hollow baffle member 40, having a plurality of apertures 36 passing therethrough, is removably coupled to an opposing opening 53 in the opposing side surface of remote manifold 12. Hollow baffle member 40 extends coaxially within upper chamber 50 and coaxially surrounds hollow tubular member 14. Attachment of both hollow tubular member 14 and hollow baffle member 40 to the side surfaces of remote manifold 12 may be accomplished by means of a base plate 32, an o-ring 37 and bolts 35 which engage each side surface of the remote manifold 12. Gas input through the inner hollow tubular member 14 is passed through aperture 34 conducting gas from the inner hollow tubular member 14 to the outer hollow baffle member 40 and is re-distributed from outer hollow baffle member 40 through the plurality of apertures 36 into upper chamber 50. The gas flow into plenum chamber 54 has, as a result of the distribution within the manifold 12, a substantially uniform velocity profile.

Plate 16 has a plurality of apertures 38 passing therethrough. Plate 16 is removably coupled to remote manifold 12 such that apertures 38 communicate with slot 56. Each of apertures 38 has an associated shutter 22 which may be adjusted to restrict desired portions of the gas flow exiting slot 56 of remote manifold 12. Shutters 22 are adjusted to desired positions to expose various sized openings in apertures 38 and shape the velocity of the uniform gas flow received from plenum chamber 54 via slot 56 as it exits the opposing surface of plate 16. The vertical directional vector of the shaped velocity gas flow is maintained as the gas flow passes through plate 16.

Main injector body 20 is configured to receive the shaped velocity vertical gas flow exiting the opposing surface of plate 16 and redirect the gas flow to a horizontal directional vector for introduction into the hollow interior 17 of the reactor 11. Main injector body 20 has a plurality of apertures 28 disposed in an upper surface 24 thereof. Plate 16 is removably coupled to the upper surface 24 of the main injector body 20 such that each of the plurality of apertures 28 in the main injector body 20 correspond to an aperture 38 in plate 16. The shaped velocity gas flow exiting from apertures 38 in plate 6 is received by apertures 28 in the main injector body 20. Upon entering apertures 28 in the main injector body 20, the gas flow maintains a vertical directional vector. As illustrated in Figures 5 and 6, the interior chamber of main injector body 20 has a generally L-shaped cross-sectional configuration. It is to be noted that the inter-aperture web between apertures 28 in the main injector body extend from the upper surface 24 of main injector body 20 to the upper edge of gas injection slot 26. Within the interior chamber of main injector body 20, the direction of the gas flow is altered from a vertical directional vector to a horizontal directional vector and exits main injector body 20 through gas injection slot 26.

As illustrated in Figure 4, it is preferable to couple the remote manifold 12, plate 16 and main injector body 20 by a plurality of bolts 30 which pass through an receiving apertures in remote manifold 12, through apertures in plate 16 and into main injector body 20. O-rings 41, to seal the coupled fittings, are interdisposed between plate 16 and remote manifold 12 as well as between plate 16 and main injector body 20 in groove 39 formed in upper surface 24 of main injector body 20. Another o-ring 49, for scaling the main injector body 20 and the CVD reactor (not shown), is disposed in the front surface of main injector body 20 and surrounds gas injection slot 26.

It will be appreciated, by those skilled in the art, that various materials may be employed, which are known to be compatible with CVD reactors and the reactant gases utilized in chemical vapor deposition processes.

It has, therefore, been found advantageous to provide a gas injection apparatus having a remote manifold for creating a uniform velocity gas flow, shaping the uniform velocity gas flow to create a shaped-velocity gas flow profile and re-directing the vertical directional flow vector to a horizontal flow vector for introduction of the shaped-velocity gas flow into the hollow interior of the reactor. The invention has been particularly described and illustrated with reference to certain embodiments thereof, but it is not intended that the invention be strictly limited to these embodiments.

## Claims

1. A gas injector apparatus (10) for an epitaxial deposition reactor, comprising: a remote manifold (12) having an upper chamber (50), a plenum chamber (54) and a outlet opening (56) associated with said plenum chamber (54); a hollow tubular member (14) having at least one aperture (34) passing therethrough, said hollow tubular member (14) being connected to a source of gas and disposed coaxially within said upper chamber (50) of said remote manifold (12); a hollow baffle member (40), having a plurality of apertures (36) passing therethrough, coaxially surrounding said hollow tubular member (14) and coaxially disposed within said upper chamber of said remote manifold (12); a plate member (16) having a plurality of openings (38) passing therethrough, said plate member (16) being coupled to said remote manifold (12) such that said plurality of openings (38) in said plate member communicate with said outlet opening (56) associated with said plenum chamber or said remote manifold (12): flow restriction means (22) associated with each of said plurality of openings (38) in said plate member, for regulating a flow of gas through said each of said plurality of openings in said plate member (16); a main injector body (20) having an upper surface (24) and a front surface and an L-shaped chamber within said main injector body (20) communicating with each of said upper surface and said front surface, said main injector body being coupled to said plate member (16) such that said plurality of openings (38) in said plate member (16) communicate with upper surface (24) and said L-shaped chamber of said main injector body.

2. The gas injector apparatus (10) according to Claim 1, wherein said plenum chamber (54) of said remote manifold (12) has parallel walls.

3. The gas injector apparatus (10) according to Claim 1, wherein said plurality of openings (38) in said plate member (16) further comprises a plurality of elongated slot openings (28) longitudinally disposed along a length of said plate member.

4. The gas injector apparatus (10) according to Claim 3, wherein said flow restriction means (22) further comprises a plurality of shutter members operably coupled to each of said plurality of elongated slot openings to adjust the size of the opening of each of said elongated slot openings.

5. The gas injector apparatus (10) according to Claim 4, wherein said upper surface of said main injector body (20) further comprises a plurality of elongated slot openings communicating with said plurality of elongated slot openings in said plate member (16) and to said L-shaped chamber of said main injector body (20).

6. The gas injector apparatus (10) according to Claim 3, wherein said front surface of said main injector body (20) further comprises a horizontally disposed gas injection opening communicating with said L-shaped chamber of said main injector body (20).

7. The gas injector apparatus (10) according to Claim 6, wherein said main injector body (20) further comprises an inter-opening web interdisposed between each of said plurality of elongated slot openings (38) and extending from said upper surface to said horizontally disposed gas injection opening in said main injector body (20).

8. In an epitaxial deposition apparatus having a reaction chamber for single substrate processing, said reaction chamber having a reaction chamber input, a gas injector apparatus (10) for injecting at least one of a reactant gas and a carrier gas into the input of the reaction chamber, said gas injector apparatus comprising: a gas injector body (20) having a front panel, a rear panel, a pair of opposing edge portions, a closed bottom and an open top defining a substantially hollow chamber (54) therein; elongated plate means adapted to be operatively disposed over said open top, said elongated plate means further having aperture means operatively disposed in said elongated plate means and flow restriction means, associated therewith, for shaping the velocity profile of said gas passing therethrough and for outputting a predetermined shaped velocity profile of said gas passing through said hollow interior and being supplied into the input of said reaction chamber through said aperture outlet means of said front panel; means for supplying a generally uniform velocity flow of said gas toward said aperture means of said elongated plate means; and aperture outlet means operatively disposed in said front panel for supplying said gas into said input of said reaction chamber.

9. Apparatus of Claim 8, wherein said hollow interior chamber of said gas injector body comprises an L-shaped chamber communicating with said front panel and said open top.

10. Apparatus of Claim 9, wherein said gas injector body further comprises a plurality of elongated slot openings longitudinally disposed in said open top and communicating with said aperture means of said elongated plate means.

11. Apparatus of Claim 10, wherein said flow restriction means further comprises a plurality of shutter members operably coupled to each of said plurality of elongated slot openings to adjust the size of the opening of each of said elongated slot openings.

12. Apparatus of Claim 11, wherein said means for supplying a generally uniform velocity gas flow further comprises: a remote manifold having an upper chamber, a plenum chamber and a outlet opening associated with said plenum chamber; a hollow tubular member having at least one aperture passing therethrough, said hollow tubular member being connected to a source of gas and disposed coaxially within said upper chamber of said remote manifold; and a hollow baffle member, having a plurality of apertures passing therethrough, coaxially surrounding said hollow tubular member and coaxially disposed within said upper chamber of said remote manifold.

13. A method for producing and injecting a gas flow having a shaped velocity profile in an epitaxial deposition reactor having a substantially hollow interior, a susceptor disposed within the interior of the reaction chamber, a gas input to the reaction chamber, a gas source, an injector having a plenum chamber, a downwardly disposed gas distribution passage, a flow-direction apparatus operatively disposed at a lower end of the gas distribution passage and an elongated output slot in a front surface of the reaction chamber, comprising the steps of: distributing a reactant gas vertically downward within the hollow interior of the plenum chamber; providing a plurality of selectively dimensioned openings in a plate means for separating the plenum chamber from the hollow interior of the gas injector; passing the reactant gas vertically downward through said dimensioned openings of said plate means thereby shaping a velocity profile of said gas flow; passing the shaped velocity profile gas flow vertically downward into the flow direction apparatus; redirecting said shaped velocity profile gas flow perpendicular to its vertically downward vector in said flow direction apparatus; and discharging said redirected shaped velocity profile gas flow through the discharge slot in the front panel of the gas injector thereby inputting a shaped velocity profile gas flow into the reaction chamber of the reactor.

## Patentansprüche

1. Gasinjektor-Vorrichtung (10) für einen Reaktor zur epitaktischen Abscheidung, die folgendes umfaßt: einen entlegenen Verteiler (12), der eine obere Kammer (50), eine Hauptkammer (54) und eine mit der genannten Hauptkammer (54) verbundene Auslaßöffnung (56) besitzt; ein hohles, röhrenförmiges Element (14), das zumindest eine dort hindurchgehende Öffnung (34) besitzt, mit einer Gasquelle verbunden und koaxial innerhalb der genannten oberen Kammer (50) dem genannten entlegenen Sammler (13) angeordnet ist; ein hohles Zwischenwandelement (40), das eine Mehrzahl von dort hindurchgehenden Öffnungen (36) besitzt, das genannte hohle, röhrenförmige Element (14) umgibt und koaxial innerhalb der oberen Kammer des genannten entlegenen Verteilers (12) angeordnet ist; ein Plattenelement (16), das eine Mehrzahl von dort hindurchgehenden Öffnungen (38) besitzt und mit dem genannten entlegenen Verteiler (12) derart verbunden ist, daß die genannte Mehrzahl von Öffnungen (38) in dem genannten Plattenelement in Verbindung steht mit der genannten Auslaßöffnung (56), die der genannten Hauptkammer oder dem genannten entlegenen Verteiler (12) zugeordnet ist; Strömungsbeschränkungsmittel (22), die jeder der Mehrzahl von Öffnungen (38) in dem genannten Plattenelement zum Regulieren einer Gasströmung durch jede der genannten Mehrzahl von Öffnungen in dem genannten Plattenelement (16) zugeordnet sind; ein Hauptinjektorkörper (20), der eine obere Fläche (24), eine Frontfläche und eine L-förmige Kammer innerhalb des genannten Hauptinjektorkörpers (20) besitzt, die sowohl mit der genannten oberen Fläche als auch der genannten Frontfläche verbunden ist, wobei der genannte Hauptinjektorkörper mit dem genannten Plattenelement (16) derart verbunden ist, daß die genannte Mehrzahl von Öffnungen (38) in dem genannten Plattenelement (16) mit der oberen Fläche (24) und der genannten L-förmigen Kammer des genannten Hauptinjektorkörpers in Verbindung steht.

2. Gasinjektor-Vorrichtung (10) gemäß Anspruch 1, in der die genannte Hauptkammer (54) des genannten entlegenen Verteilers (12) parallele Wände besitzt.

3. Gasinjektor-Vorrichtung (10) gemäß Anspruch 1, in der die genannte Mehrzahl von Öffnungen (38) in dem genannten Plattenelement (16) weiterhin eine Mehrzahl von länglichen Spaltöffnungen (28) umfaßt, die längs verlaufend entlang einer Länge des genannten Plattenelements angeordnet sind.

4. Gasinjektor-Vorrichtung (10) gemäß Anspruch 3, in der die genannten Strömungsbeschränkungsmittel (22) weiterhin eine Mehrzahl von Schließelementen umfaßt, die betrieblich mit jeder der genannten zahlreichen verlängerten Spaltöffnungen zum Anpassen der Größe einer Öffnung von jeder der genannten länglichen Spaltöffnungen verbunden ist.

5. Gasinjektor-Vorrichtung (10) gemäß Anspruch 4, in der die genannte obere Fläche des genannten Hauptinjektorkörpers (20) weiterhin eine Mehrzahl von länglichen Spaltöffnungen umfaßt, die mit der genannten Mehrzahl von länglichen Spaltöffnungen in dem genannten Plattenelement (16) und mit der genannten L-förmigen Kammer des genannten Hauptinjektorkörpers (20) in Verbindung steht.

6. Gasinjektor-Vorrichtung (10) gemäß Anspruch 3, in der die genannte Frontfläche des Hauptinjektorkörpers (20) weiterhin eine horizontal angeordnete Gasinjektionsöffnung umfaßt, die mit der genannten L-förmigen Kammer des genannten Hauptinjektorkörpers (20) in Verbindung steht.

7. Gasinjektor-Vorrichtung (10) gemäß Anspruch 6, in der der Hauptinjektorkörper (20) weiterhin ein Zwischenöffnungsstück umfaßt, das zwischen jeder der genannten Mehrzahl länglichen Spaltöffnungen (38) angeordnet ist und von der genannten oberen Fläche bis zu der genannten horizontal angeordneten Gasinjektoröffnung in dem genannten Hauptinjektionskörper (20) reicht.

8. Vorrichtung zum epitaktischen Abscheiden mit einer Reaktionskammer für einzelne Substratbehandlung die einen Reaktionskammereinlaß, eine Gasinjektions-Vorrichtung (10) zum Injizieren zumindest eines reaktanten und/oder eines Trägergases in den Einlaß der Reaktionskammer besitzt, wobei die genannte Gasinjektor-Vorrichtung folgendes umfaßt: einen Gasinjektorkörper (20), der eine Frontplatte, eine Rückplatte, ein Paar gegenüberliegender Randteile, einen geschlossenen Boden und eine offene Oberseite besitzt, die eine im wesentlichen hohle Kammer (54) darin umgrenzen; ein längliches Plattenelement, das betrieblich über der genannten offenen Oberseite angeordnet werden kann, wobei das genannten längliche Plattenelement weiterhin Öffnungsmittel aufweist, die betrieblich in dem genannten länglichen Plattenelement und den damit verbundenen Strömungsbeschränkungsmitteln angeordnet sind, zum Formen des Geschwindigkeitsprofils des genannten dort hindurchgehenden Gases und zum Erzeugen eines vorherbestimmt geformten Geschwindigkeitsprofils des genannten Gases, das durch das genannte hohle Innere hindurchgeht und in den Einlaß der genannten Reaktionskammer durch die genannten Auslaßöffnungsmittel der genannten Frontplatte geliefert wird; Mittel zum Liefern eines Stroms von im allgemeinen gleichförmiger Geschwindigkeit des genannten Gases zu den genannten Öffnungsmitteln des genannten länglichen Plattenelements hin; und Auslaßöffnungsmittel, die betrieblich in der genannten Frontplatte angeordnet sind, zum Liefern des genannten Gases in den genannten Einlaß der genannten Reaktionskammer.

9. Vorrichtung nach Anspruch 8, in der die hohle, innenliegende Kammer des genannten Gasinjektorkörpers eine L-förmige Kammer umfaßt, die mit dar genannten Frontplatte und der genannten offenen Oberseite in Verbindung steht.

10. Vorrichtung nach Anspruch 9, in der der genannte Gasinjektorkörper weiterhin eine Mehrzahl von länglichen Spaltöffnungen umfaßt, die längs verlaufend angeordnet sind in der genannten offenen Oberseite und die mit den genannten Öffnungsmitteln des genannten länglichen Plattenelements verbunden sind.

11. Vorrichtung nach Anspruch 10, in der die genannten Strömungsbeschränkungsmittel weiterhin eine Mehrzahl von Schließelementen umfaßt, die beweglich mit jeder der Mehrzahl der länglichen Spaltöffnungen zum Anpassen der Größe der Öffnung von jeder der genannten länglichen Spaltöffnungen verbunden ist.

12. Vorrichtung nach Anspruch 11, in der die genannten Mittel zum Liefern eines Stroms von im allgemeinen gleichförmiger Geschwindigkeit weiterhin folgendes umfassen: einen entlegenen Verteiler, der eine obere Kammer besitzt, eine Hauptkammer und eine Auslaßöffnung, die mit der genannten Hauptkammer verbunden ist; ein hohles, röhrenförmiges Element, das zumindest eine dort hindurchgehende Öffnung besitzt, wobei das hohle, röhrenförmige Element mit einer Gasquelle verbunden und koaxial innerhalb der genannten oberen Kammer des entlegenen Verteilers angeordnet ist; und ein hohles Zwischenwandelement, das eine Mehrzahl von dort hindurchgehenden Öffnungen besitzt, die koaxial das genannte hohle, röhrenförmige Element umgeben und koaxial innerhalb der genannten oberen Kammer des genannten entlegenen Verteilers angeordnet sind.

13. Verfahren zum Herstellen und Injizieren eines Gasstroms, der ein ausgeformtes Geschwindigkeitsprofil hat, in einem Reaktor zur epitaktischen Abscheidung, der ein im wesentlichen hohles Innere, einen innerhalb des Inneren der Reaktionskammer angeordneten Suszeptor, einen Gaseinlaß in die Reaktionskammer, eine Gasquelle und einen Injektor aufweist, der eine Hauptkammer, einen nach unten angeordneten Gasverteilungskanal, eine Strömungsrichteinrichtung, die betrieblich an einem unteren Ende des Gasverteilungskanals angeordnet ist, und einen länglichen Auslaßspalt in einer Vorderfläche der Reaktionskammer besitzt, das die folgenden Schritte umfaßt: Verteilen eines reaktanten Gases vertikal nach unten innerhalb des hohlen Inneren der Hauptkammer; Vorsehen einer Mehrzahl von wählbar dimensionierten Öffnungen in einem Plattenelement zum Trennen der Hauptkammer von dem hohlen Inneren des Gasinjektors; Führen des reaktanten Gases vertikal nach unten durch die genannten dimensionierten Öffnungen des genannten Plattenelements, dadurch Formen eines Geschwlndigkeitsprofils des genannten Gasstroms; Führen des Gasstroms mit ausgeformtem Geschwindigkeitsprofil vertikal nach unten in die Strömungsrichteinrichtung; Umlenken des genannten Gasstroms mit ausgeformtem Geschwindigkeitsprofil lotrecht zu seinem vertikal nach unten weisenden Vektor in der genannten Strömungsrichteinrichtung; und Ausstoßen des genannten umgelenkten Gasstroms mit ausgeformtem Geschwindigkeitsprofil durch den Auslaßspalt in die Frontplatte des Gasinjektors, dadurch Einbringen eines Gasstroms mit ausgeformtem Geschwindigkeitsprofil in die Reaktionskammer des Reaktors.

## Revendications

1. Dispositif injecteur de gaz (10) pour un réacteur de dépôt épitaxial, comprenant: un collecteur éloigné (12) présentant une chambre supérieure (50), une chambre de confinement de milieu (54) et une ouverture de sortie (56) associée à ladite chambre de confinement (54); un organe tubulaire creux (14) présentant au moins une ouverture (34) le traversant, ledit organe tubulaire creux (14) étant relié à une source de gaz et disposé coaxialement à l'intérieur de ladite chambre supérieure (50) dudit collecteur éloigné (12); un organe déflecteur creux (40), présentant une pluralité d'ouvertures (36) le traversant, entourant coaxialement ledit organe tubulaire creux (14) et disposé coaxialement à l'intérieur de ladite chambre supérieure dudit collecteur éloigné (12); un organe plat (16) présentant une pluralité d'ouvertures (38) le traversant, ledit organe plat (16) étant couplé audit collecteur éloigné (12), de manière que ladite pluralité d'ouvertures (38) ménagées dans ledit organe plat communique avec ladite ouverture de sortie (56) associée à ladite chambre de confinement ou ledit collecteur éloigné (12); un moyen de limitation d'écoulement (22) associé à chaque ouverture de la pluralité d'ouvertures (38) ménagées dans ledit organe plat, pour réguler un écoulement de gaz passant dans chaque dite ouverture de ladite pluralité d'ouvertures ménagées dans ledit organe plat (16); un corps d'injection principal (20) présentant une surface supérieure (24) et une surface avant et une chambre en forme de L, située dans ledit corps d'injection principal (20) communiquant avec chaque surface parmi ladite surface supérieure et ladite surface avant, ledit corps d'injection principal étant couplé audit organe plat (16), de manière que ladite pluralité d'ouvertures (38) ménagées dans ledit organe plat (16) communique avec la surface supérieure (24) et ladite chambre en forme de L dudit corps d'injection principal.

2. Dispositif injecteur de gaz (10) selon la revendication 1, dans lequel ladite chambre de confinement (54) dudit collecteur éloigné (12) présente des parois parallèles.

3. Dispositif injecteur de gaz (10) selon la revendication 1, dans lequel ladite pluralité d'ouvertures (38) ménagées dans ledit organe plat (16) comprend en outre une pluralité d'ouvertures en forme de fente allongées (28), ménagées longitudinalement sur une longueur dudit organe plat.

4. Dispositif injecteur de gaz (10) selon la revendication 3, dans lequel ledit moyen de limitation d'écoulement (22) comprend en outre une pluralité d'organes obturateurs couplés de façon fonctionnelle à chaque ouverture de ladite pluralité d'ouvertures en forme de fente allongées, pour ajuster la taille de l'ouverture de chacune desdites ouvertures en forme de fente allongées.

5. Dispositif injecteur de gaz (10) selon la revendication 4, dans lequel ladite surface supérieure dudit corps d'injection principal (20) comprend en outre une pluralité d'ouvertures en forme de fente allongées communiquant avec ladite pluralité d'ouvertures en forme de fente allongées ménagées dans ledit organe plat (16) et vers ladite chambre en forme de L dudit corps d'injection principal (20).

6. Dispositif injecteur de gaz (10) selon la revendication 3, dans lequel ladite surface avant dudit corps d'injection principal (20) comprend en outre une ouverture d'injection de gaz ménagée horizontalement, communiquant avec ladite chambre en forme de L dudit corps d'injection principal (20).

7. Dispositif injecteur de gaz (10) selon la revendication 6, dans lequel ledit corps d'injection principal (20) comprend en outre un voile inter-ouvertures, disposé entre chaque ouverture de ladite pluralité d'ouvertures en forme de fente allongées (38) et s'étendant de ladite surface supérieure à ladite ouverture d'injection de gaz, ménagée horiontalement dans ledit corps d'injection principal (20).

8. Dans un appareil de dépôt épitaxial présentant une chambre de réaction pour un traitement de substrat unique, ladite chambre de réaction présentant une entrée de chambre de réaction, un dispositif injecteur de gaz (10) pour injecter au moins l'un d'un gaz réactif et d'un gaz porteur dans l'entrée de la chambre de réaction, ledit dispositif injecteur de gaz comprenant: un corps d'injection de gaz (20) présentant un panneau avant, un panneau arrière, un couple de parties de bord opposées, une face inférieure fermée et une face supérieure ouverte définissant en son sein une chambre sensiblement creuse (54); un moyen plat allongé adapté pour être disposé de façon fonctionnelle sur ladite face supérieure ouverte, ledit moyen plat allongé présentant en outre un moyen d'ouverture ménagé de façon fonctionnelle dans ledit moyen plat allongé et un moyen de limitation d'écoulement lui étant associé, pour former le profil de vitesse dudit écoulement de gaz le traversant et pour produire un profil de vitesse conformé prédéterminé dudit écoulement de gaz passant dans l'intérieur creux et fourni à l'entrée de ladite chambre de réaction, par l'intermédiaire dudit moyen de sortie à ouverture dudit panneau avant; un moyen pour produire un écoulement dudit gaz à vitesse généralement uniforme vers ledit moyen d'ouverture dudit moyen plat allongé; et un moyen de sortie à ouverture disposé de façon fonctionnelle dans ledit panneau avant, pour fournir ledit gaz à ladite entrée de ladite chambre de réaction.

9. Appareil selon la revendication 8, dans lequel ladite chambre intérieure creuse dudit corps d'injection de gaz comprend une chambre en forme de L communiquant avec ledit panneau de face et ladite face supérieure ouverte.

10. Dispositif selon la revendication 9, dans lequel ledit corps d'injection de gaz comprend une pluralité d'ouvertures en forme de fente allongées, ménagées longitudinalement dans ladite face supérieure ouverte et communiquant avec ledit moyen d'ouverture dudit moyen plat allongé.

11. Appareil selon la revendication 10, dans lequel ledit moyen de limitation d'écoulement comprend en outre une pluralité d'organes obturateurs couplés de façon fonctionnelle à chaque ouverture de ladite pluralité d'ouvertures en forme de fente allongées, pour ajuster la taille de l'ouverture de chacune desdites ouvertures en forme de fente allongées.

12. Appareil selon la revendication 11, dans lequel ledit moyen pour fournir un écoulement de gaz à vitesse généralement uniforme comprend en outre: un collecteur éloigné présentant une chambre supérieure, une chambre de confinement de milieu et une ouverture de sortie associée à ladite chambre de confinement; un organe tubulaire creux présentant au moins une ouverture le traversant, ledit organe tubulaire creux étant relié à une source de gaz et disposé coaxialement à l'intérieur de ladite chambre supérieure dudit collecteur éloigné; et un organe de déflecteur creux, présentant une pluralité d'ouvertures le traversant, entourant coaxialement ledit organe tubulaire creux et disposé coaxialement à l'intérieur de ladite chambre supérieure dudit collecteur éloigné.

13. Procédé pour produire et injecter un écoulement de gaz présentant un profil de vitesse conformé dans un réacteur de dépôt épitaxial présentant un intérieur sensiblement creux, un élément sensible disposé à l'intérieur de la chambre de réaction, une entrée de gaz pour la chambre de réaction, une source de gaz, un injecteur présentant une chambre de confinement, un passage de distribution de gaz disposé vers le bas, un dispositif d'orientation d'écoulement disposé de façon fonctionnelle à une extrémité inférieure du passage de distribution de gaz et une fente de sortie allongée ménagée dans une surface avant de la chambre de réaction, comprenant les étapes de: distribution d'un gaz réactif verticalement vers le bas, dans l'intérieur creux de la chambre de confinement; agencement d'une pluralité d'ouvertures dimensionnées de façon sélective dans un moyen plat, pour séparer la chambre de confinement de l'intérieur creux de l'injecteur de gaz; passage du gaz réactif verticalement vers le bas, par l'intermédiaire desdites ouvertures dimensionnees dudit moyen plat, de manière à conformer un profil de vitesse dudit écoulement de gaz; passage dudit écoulement de gaz à profil de vitesse conformé verticalement vers le bas, dans le dispositif d'orientation d'écoulement; réorientation dudit écoulement de gaz à profil de vitesse conformé, de façon perpendiculaire à son vecteur orienté verticalement vers le bas dans ledit dispositif d'orientation d'écoulement; et évacuation dudit écoulement de gaz à profil de vitesse conformé réorienté par l'intermédiaire de la fente d'évacuation ménagée dans le panneau avant de l'injecteur de gaz, de manière à faire entrer un écoulement de gaz à profil de vitesse conformé dans la chambre de réaction du réacteur.
